# EUROPEAN PATENT APPLICATION

(11) **EP 0 798 751 A1**
(43) Date of publication of application: **01.10.1997**
(21) Application number: 96932842.6
(22) Date of filing: 08.10.1996
(51) Int. Cl.: H01F 10/06, G01R 33/02

(54) **AMORPHOUS MAGNETIC SUBSTANCE AND MAGNETIC SENSOR**

(30) Priority: 13.10.1995 JP 265069/95
(71) Applicant: SUMITOMO METAL MINING COMPANY LIMITED, Tokyo 105 (JP)
(72) Inventor: MONMA, Akio, Chiba 272 (JP); YAMANOBE, Yasunori, Chiba 272 (JP)
(74) Representative: Gerbaulet, Hannes
(86) International application number: JP9602920
(87) International publication number: WO9714161

(57) **Abstract**

It is an object of the present invention to provide a magnetic sensor having a magnetic field detecting section preventing amorphous magnetic substance from being entirely covered with solder and providing constant magnetic field detecting effective length L_{eff} of amorphous magnetic substance, and amorphous magnetic substance employed in the magnetic sensor.

An amorphous magnetic substance wire 1 is formed at two sites of a surface thereof, or at opposite ends thereof with electrodes 7 coated with non-magnetic electrically conductor, and the electrodes define a magnetic field detecting effective length L_{eff} therebetween. A magnetic field detecting section 10 of a magnetic sensor 100 includes the amorphous magnetic substance wire 1 defining the magnetic field detecting effective length L_{eff}. A distance Lco between the electrodes of the amorphous magnetic substance wire 1 can be defined with accuracy on the order of µm by coating the amorphous magnetic substance wire with non-magnetic electrically conductive material, and the magnetic field detecting effective length L_{eff} of the amorphous magnetic substance wire 1 can be defined with accuracy on the order of µm. As a result, measurement accuracy of the magnetic sensor is enhanced without influenced by solder 2.

## Description

### TECHNICAL FIELD

The present invention relates to amorphous magnetic substance which have an electrode formed on a surface thereof and which is in the form of wire, ribbon, or a thin film and the like, and further relates to a magnetic sensor employing the magnetic substance in a magnetic field detecting section.

### BACKGROUND ART

Amorphous magnetic substance, for instance, known as having a Fe-Si-B family composition, is often used in a detecting section of a magnetic sensor because of MI (magnetic-impedance) effect thereof. A magnetic sensor employing amorphous magnetic substance can detect quite small fluctuation in magnetic field such as earth magnetism, and these days attracts attention because it can be fabricated smaller in size, lighter and cheaper than a conventional flux gate type magnetic sensor.

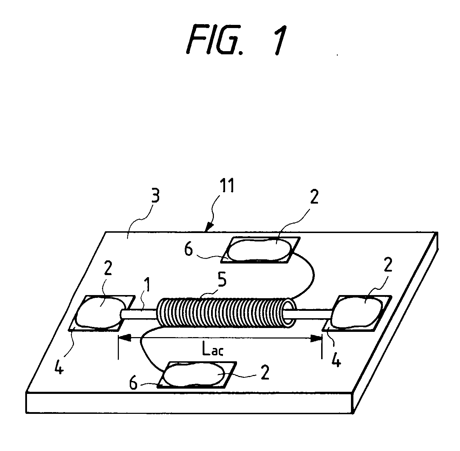

Fig. 1 is a perspective view illustrating a magnetic field detecting section 11 employing a conventional amorphous magnetic substance wire. An amorphous magnetic substance wire 1 is fixed at its opposite ends to wire electrodes 4 on a substrate 3 through solder 2. The amorphous magnetic substance wire 1 is centrally inserted into a coil 5 which generates a bias magnetic field. The coil 5 is fixed at its opposite ends to coil electrodes 6 on the substrate 3 through the solder 2 in the same manner as the amorphous magnetic substance wire 1 being fixed to the electrodes.

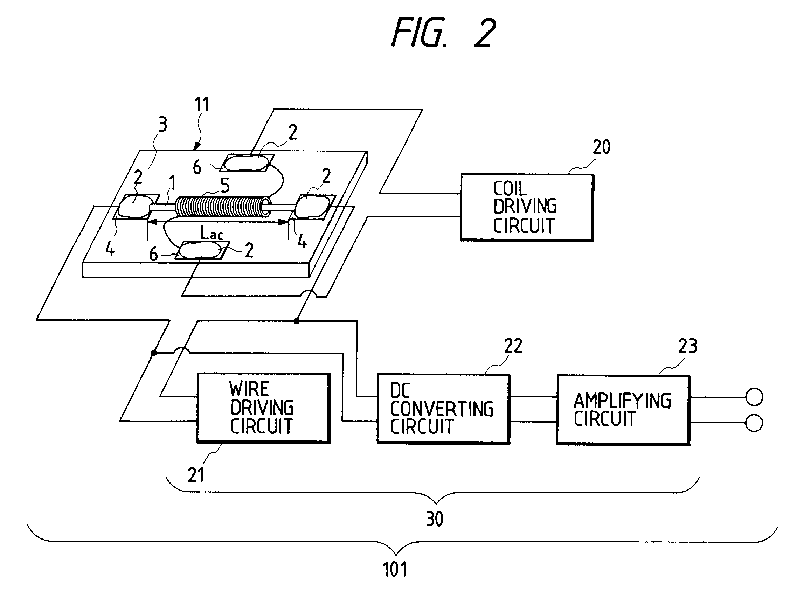

Fig. 2 illustrates a conventional magnetic sensor 101. The conventional magnetic sensor 101 is comprised of a magnetic field detecting section 11 and a signal processing circuit 30. The signal processing circuit 30 includes a coil driving circuit 20, a wire driving circuit 21, a dc converting circuit 22, and an amplifying circuit 23. The coil driving circuit 20 is connected to the opposite ends of the coil 5, and is designed to generate a magnetic field around the coil 5 by applying a dc current to the coil, and control a magnitude of the magnetic field generated by the coil 5 to be a desired magnitude. The wire driving circuit 21 is connected to the opposite ends of the amorphous magnetic substance wire 1, and is designed to apply, for instance, a high frequency current to and thereby drive the amorphous magnetic substance wire 1 to thereby generate a voltage across the amorphous magnetic substance wire 1. In addition, the dc converting circuit 22 is connected also to the opposite ends of the amorphous magnetic substance wire 1, and is designed to convert an ac voltage signal generated by the wire driving circuit 21 into a dc voltage signal and transmit the thus converted dc voltage signal to the amplifying circuit 23. The amplifying circuit 23 is connected to the dc converting circuit 22, and is designed to amplify dc voltage signals input thereto. Thus, the magnetic sensor 101 can detect an impedance of the amorphous magnetic substance wire 1, based on the dc voltage signals and a current value transmitted thereto from the wire driving circuit 21.

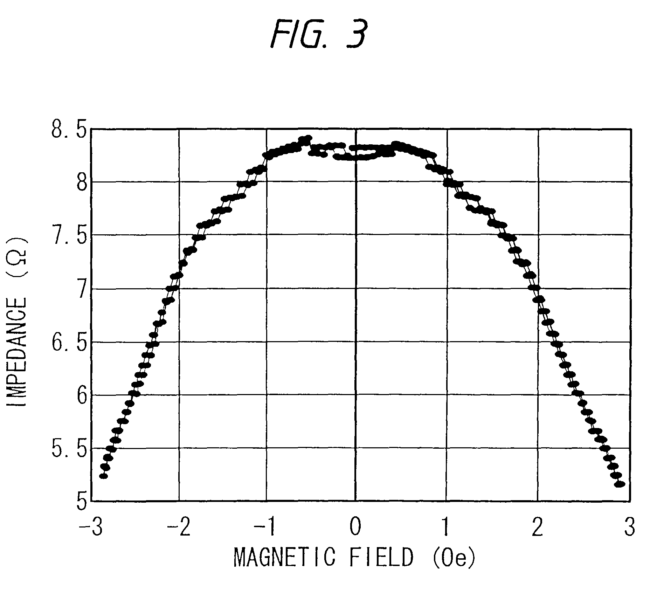

Fig. 3 illustrates a graph having an abscissa axis indicating a magnitude of magnetic field at an outer surface of the amorphous magnetic substance wire 1, and an ordinate axis indicating an impedance of the amorphous magnetic substance wire 1, showing the dependency of an impedance of the amorphous magnetic substance wire 1 on an external magnetic field. As illustrated in Fig. 3, the amorphous magnetic substance wire 1 has a characteristic that an impedance thereof is varied with an external magnetic field. Hence, the magnetic sensor 101 illustrated in Fig. 2 can detect a magnitude of an external magnetic field in accordance with variation in an impedance of the amorphous magnetic substance wire 1.

The above mentioned conventional magnetic field detecting section 11 is structured to electrically connect the amorphous magnetic substance wire 1 to the electrodes 4 through the solders 2. However, such a structure in which a wire is electrically connected to an electrode through a solder has a problem that since the amorphous magnetic substance wire 1 has poor wettability, an effective length of the amorphous magnetic substance wire 1 for detecting a magnetic field (hereinafter, referred to as "magnetic field detecting effective length") L_{eff} is entirely covered with a solder, and hence may be varied.

For instance, when the amorphous magnetic substance wire 1 is connected to the wire electrodes 4 with a distance Lac between the wire electrodes being 4.00 mm, there is generated a dispersion about 20% in a resistance value of the magnetic field detecting section (external magnetic field = 0). If such a magnetic field detecting section is employed in a magnetic sensor, there is generated a greater dispersion in an output value of a magnetic sensor, because an output value of a magnetic sensor is varied due to a dispersion in a resistance value of individual magnetic field detecting sections. Hence, there is posed a problem that it is impossible to know as to whether a magnetic sensor detects either a dispersion in a resistance value of the amorphous magnetic substance wire 1 employed in the magnetic sensor or a magnitude of a magnetic field.

In view of the above mentioned problems of the conventional magnetic sensor, it is an object of the present invention to provide a magnetic sensor having a magnetic field detecting section preventing amorphous magnetic substance from being entirely covered with solder and providing constant magnetic field detecting effective length L_{eff} of amorphous magnetic substance, and amorphous magnetic substance employed in the magnetic sensor.

### DISCLOSURE OF THE INVENTION

In order to achieve the above mentioned object, amorphous magnetic substance to be used for a magnetic sensor in accordance with the present invention is characterized by non-magnetic electrically conductive material coated on a surface of the amorphous magnetic substance at more than two sites to thereby form electrodes, an effective length of a detecting section being defined as a distance between the electrodes. The amorphous magnetic substance is also characterized by that the non-magnetic electrically conductive material is coated by plating, evaporation, sputtering, ion-plating or screen printing. The amorphous magnetic substance is further characterized by that the electrodes are formed by screen printing, etching or lift-off. A magnetic sensor in accordance with the present invention is characterized by having a detecting section composed of one of the above mentioned amorphous magnetic substance.

### BRIEF DESCRIPTION OF THE DRAWINGS

Fig. 1 is a schematic view illustrating a magnetic field detecting section of a conventional magnetic sensor.

Fig. 2 is a schematic view illustrating a conventional magnetic sensor.

Fig. 3 is a graph showing an example of impedance vs. magnetic field characteristic of the amorphous magnetic substance wire.

Fig. 4 is a schematic view illustrating an embodiment of a magnetic field detecting section of a magnetic sensor employing amorphous magnetic substance in accordance with the present invention.

Fig. 5 is a schematic view illustrating an embodiment of a magnetic sensor in accordance with the present invention.

Fig. 6 is a flow chart of an embodiment of a process for forming electrodes made of non-magnetic electrically conductive material coated on amorphous magnetic substance.

### BEST MODE FOR CARRYING OUT THE INVENTION

The present invention will be described hereinbelow in detail with reference to the attached drawings.

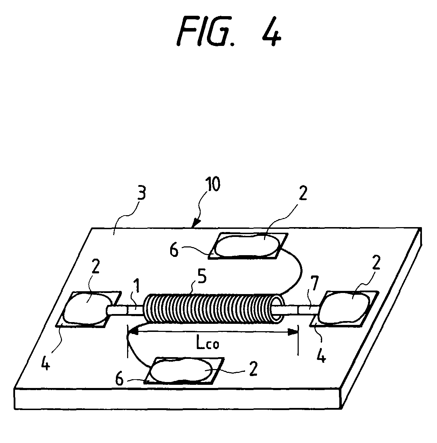

Fig. 4 is a schematic view illustrating an embodiment of a magnetic field detecting section of a magnetic sensor employing amorphous magnetic substance in accordance with the present invention. An amorphous magnetic substance wire 1 is formed at two sites of a surface thereof, or at opposite ends thereof with electrodes 7 coated with non-magnetic electrically conductor by plating, and is connected to wire electrodes 4 on a substrate 3 by means of solder 2 through the electrodes 7 coated with non-magnetic electrically conductor. The amorphous magnetic substance wire 1 is centrally inserted into a coil 5 which generates a bias magnetic field. The coil 5 is fixed at its opposite ends to coil electrodes 6 on the substrate 3 through the solder 2 in the same manner as the amorphous magnetic substance wire 1 being fixed to the electrodes.

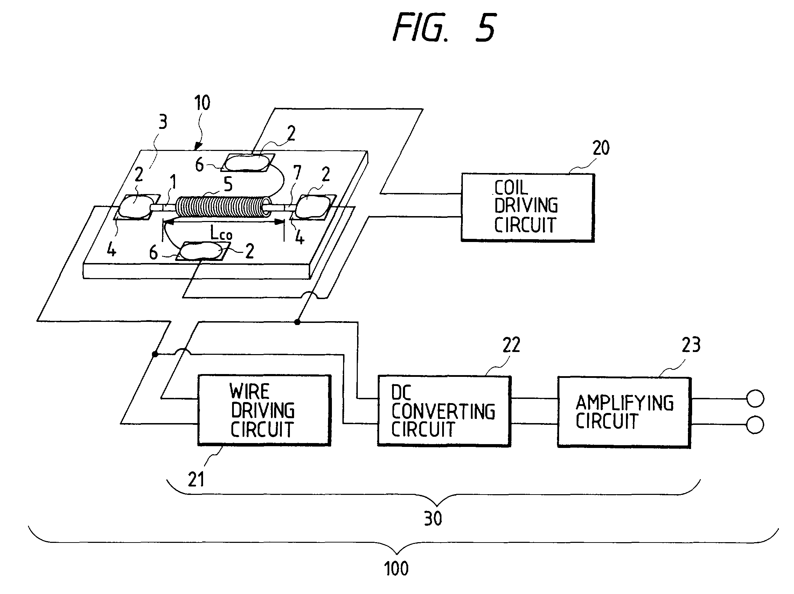

Fig. 5 is a schematic view illustrating an embodiment of a magnetic sensor in accordance with the present invention. The magnetic sensor 100 is comprised of a magnetic field detecting section 10 and a signal processing circuit 30. The signal processing circuit 30 includes a coil driving circuit 20, a wire driving circuit 21, a dc converting circuit 22, and an amplifying circuit 23. The coil driving circuit 20 is connected to the coil 5, and is designed to generate a bias magnetic field around the coil 5 by applying a dc current to the coil, and control a magnitude of the magnetic field generated by the coil 5 to be a desired magnitude. The wire driving circuit 21 is connected to the opposite ends of the amorphous magnetic substance wire 1, and is designed to apply, for instance, a high frequency current to and thereby drive the amorphous magnetic substance wire 1 to thereby generate a voltage across the amorphous magnetic substance wire 1. In addition, the dc converting circuit 22 is connected also to the opposite ends of the amorphous magnetic substance wire 1, and is designed to convert an ac voltage signal generated by the wire driving circuit 21 into a dc voltage signal and transmit the thus converted dc voltage signal to the amplifying circuit 23. The amplifying circuit 23 is connected to the dc converting circuit 22, and is designed to amplify dc voltage signals transmitted thereto. Thus, the magnetic sensor 100 can detect an impedance of the amorphous magnetic substance wire 1, based on the dc voltage signals and a current value transmitted thereto from the wire driving circuit 21.

Since the amorphous magnetic substance wire 1 has a characteristic that an impedance thereof varies in accordance with a magnetic field, as illustrated in Fig. 3, the magnetic sensor 100 illustrated in Fig. 5 can detect a magnitude of an external magnetic field based on variation in an impedance of the amorphous magnetic substance wire, similarly to the conventional magnetic sensor 101 illustrated in Fig. 2.

The amorphous magnetic substance in accordance with the present invention is formed with electrodes by coating non-magnetic electrically conductive material thereon, and the magnetic field detecting effective length L_{eff} is defined by the electrodes. The magnetic sensor in accordance with the present invention employs amorphous magnetic substance having a magnetic field detecting effective length L_{eff} defined with electrodes formed by coating non-magnetic electrical conductor on the amorphous magnetic substance. The magnetic field detecting effective length L_{eff} of the amorphous magnetic substance wire 1 is dependent on accuracy of a distance Lco between the electrodes. By coating non-magnetic electrical conductor on amorphous magnetic substance like the present invention, the distance Lco between the electrodes can be defined with accuracy on the order of µm by means of conventional photolithography technique. Thus, when the amorphous magnetic substance wire 1 is incorporated into the magnetic field detecting section 10 illustrated in Fig. 4, the effective length L_{eff} of the amorphous magnetic substance wire 1 can be defined with accuracy on the order of µm without entirely covering the effective length L_{eff} with solder.

There may be used copper, gold, silver, platinum, aluminum, brass or alloy thereof as non-magnetic electrically conductive material for coating a surface of the amorphous magnetic substance wire 1 therewith.

In order to coat the amorphous magnetic substance with non-magnetic electrically conductive material, there may be chosen any conventional methods such as plating, evaporation, sputtering, ion-plating and screen printing. The electrodes may be formed by any conventional methods such as screen printing, etching and lift-off. These methods may be carried out in combination. In addition, the amorphous magnetic substance in accordance with the present invention may be in the form of wire, ribbon or a thin film. The magnetic sensor employing the amorphous magnetic substance in accordance with the present invention may be widely used regardless of a structure of a sensor.

Hereinbelow will be explained an embodiment in accordance with the present invention.

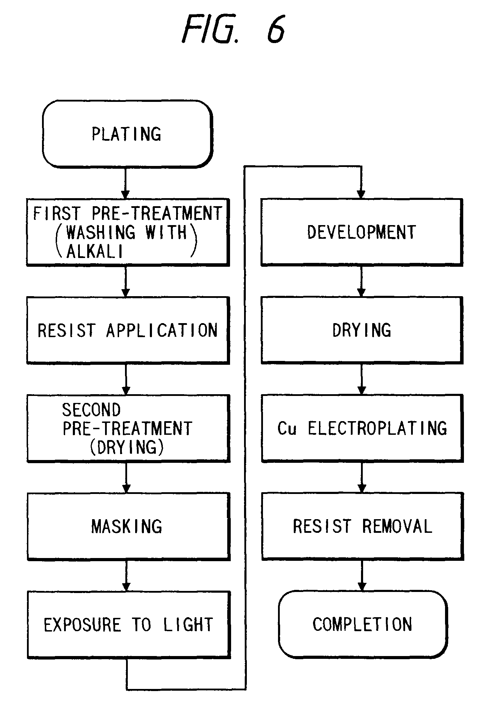

A magnetic field detecting section as illustrated in Fig. 4 was fabricated employing the amorphous magnetic substance in accordance with the present invention, and was evaluated. The amorphous magnetic substance wire 1 employed was composed of (Fe₆Co₉₄)_{72.5}Si_{12.5}B₁₅, and had a diameter of 30 µm and an entire length of 6 mm. The coil 5 had 200 turns and a diameter of 1 mm, and the coil driving circuit 20 was adjusted to generate a magnetic field having a magnitude of about 2 Oe. The substrate 3 was made of glass epoxy, and was 10 mm × 10 mm in size and 1.6 mm thick. The amorphous magnetic substance wire 1 was formed at its opposite ends with Cu electrodes through the process illustrated in Fig. 6.

There were fabricated 23 magnetic field detecting sections as illustrated in Fig. 4 including the amorphous magnetic substance wire 1 formed with Cu electrodes through the above mentioned process, and a resistance value of each of the magnetic field detecting sections was measured. The results were as follows: an average in resistance values of the magnetic field detecting sections is 6.95 Ω, a dispersion in the 23 magnetic field detecting sections is below 2%. Namely, a dispersion is significantly reduced in comparison with the dispersion of 20% of conventional magnetic field detecting sections. Herein, a term "dispersion" means a percentage of a difference between maximum and minimum resistance values of the magnetic field detecting sections obtained whet, an external magnetic field is measured, divided by an average of the resistance values.

Thus, the use of the magnetic field detecting section including the amorphous magnetic substance coated with non-magnetic electrical conductor at more than two sites on a surface thereof makes it possible to reduce the degree of variation in the magnetic field detecting effective length L_{eff} of individual magnetic field detecting sections which variation is caused by amorphous magnetic substance entirely covered with solder, and was a problem in conventional magnetic field detecting section. The magnetic sensor in accordance with the present invention can be obtained by arranging the magnetic field detecting section 10 into which the amorphous magnetic substance is incorporated, in such a circuitry as illustrated in Fig. 5. If the magnetic field detecting section 10 have such a small dispersion as mentioned above is employed, the magnetic sensor 100 can detect only a magnitude of an external magnetic field, resulting in enhancement of measurement accuracy.

As mentioned above, it is possible to significantly reduce the degree of deviation in the magnetic field detecting effective length L_{eff} by employing the inventive amorphous magnetic substance in a magnetic field detecting section, and it is also possible to eliminate for the most part a variation in output of a magnetic sensor caused by inconsistency of the magnetic field detecting effective length L_{eff}, by employing the magnetic field detecting section in a magnetic sensor.

In addition, in accordance with the magnetic sensor of the present invention, it is possible to remarkably reduce the dispersion, and hence it is no longer necessary to prepare steps or circuits for depressing the dispersion, which allows mass production of magnetic sensors. Thus, the present invention highly contributes to a field of a sensor a demand of which will more and more increase.

### INDUSTRIAL APPLICABILITY

As mentioned so far, the amorphous magnetic substance in accordance with the present invention and the magnetic sensor employing the same are useful as a sensor for detecting a small variation in a magnetic field such as earth magnetism, or as a proximity sensor to which the magnetic sensor is applied.

## Claims

1. Amorphous magnetic substance having non-magnetic electrically conductive material coated on a part of a surface thereof.

2. Amorphous magnetic substance having non-magnetic electrically conductive material coated on a surface thereof at more than two sites to thereby form electrodes, an effective length of a detecting section being defined as a distance between said electrodes.

3. Amorphous magnetic substance as set forth in claim 1 or 2, wherein said non-magnetic electrically conductive material is coated by plating, evaporation, sputtering, ion-plating or screen printing.

4. Amorphous magnetic substance as set forth in claim 2, wherein said electrodes are formed by screen printing, etching or lift-off.

5. A magnetic sensor including a detecting section composed of the amorphous magnetic substance as set forth in any one of claims 1 to 4.
